# FASCICULE DE BREVET EUROPEEN

(11) **EP 0 911 431 B1**
(45) Date de publication et mention de la délivrance du brevet: **13.08.2003**
(21) Numéro de dépôt: 98410117.0
(22) Date de dépôt: 14.10.1998
(51) Int. Cl.: C30B 33/00, H01L 29/02

(54) **Amélioration de la résistance mécanique d'une tranche de silicium monocristallin**
Einkristalline Siliciumscheibe mit einer erhöhten mechanischen Festigkeit
Single crystal silicon wafer with increased mechanical resistance

(30) Priorité: 15.10.1997 FR 9713130
(43) Date de publication de la demande: 28.04.1999
(73) Titulaire: STMicroelectronics S.A., 92120 Montrouge (FR)
(72) Inventeur: Vandeputte, Jacques, 37390 Charentilly (FR); Bourdet, Florine, 37100 Tours (FR)
(74) Mandataire: de Beaumont, Michel

(56) Documents cités:
- EP-A- 0 137 914
- DD-A- 217 246
- DE-A- 3 900 526
- US-A- 4 338 481
- PATENT ABSTRACTS OF JAPAN vol. 8, no. 191 (M-322), 4 septembre 1984 & JP 59 081057 A (HITACHI SEISAKUSHO KK), 10 mai 1984
- PATENT ABSTRACTS OF JAPAN vol. 4, no. 15 (E-170), 5 février 1980 & JP 54 156480 A (MITSUBISHI ELECTRIC CORP)
- PATENT ABSTRACTS OF JAPAN vol. 12, no. 425 (E-681), 10 novembre 1988 & JP 63 164273 A (AISIN SEIKI CO LTD), 7 juillet 1988
- SEMI: "Book of SEMI Standards, Materials Volume", 1996, SEMI 1978,1995, 805 EAST MIDDLEFIELD ROAD, MOUNTAIN VIEW, CA 94043

## Description

La présente invention concerne la fabrication de composants semiconducteurs à partir d'une tranche de silicium monocristallin.

Pour fabriquer des composants semiconducteurs discrets ou intégrés dans du silicium, on commence par couper des tranches dans un lingot de silicium monocristallin, dans lesquelles sont généralement formés de nombreux composants identiques. Les tranches sont généralement soumises à un polissage pour obtenir une planéité et un parallélisme de surfaces adaptés aux traitements ultérieurs des tranches.

Les tranches polies sont ensuite soumises à différents traitements de dopage pour créer des régions semiconductrices ayant des dopages différents selon les motifs des composants à réaliser. Selon les applications, généralement dans le cas des circuits intégrés, les composants sont formés à partir d'une face dite "avant" de la tranche et tous les contacts métalliques correspondants se trouvent sur la face avant. Pour des composants de puissance ou haute tension, les composants sont formés dans l'épaisseur de la tranche de silicium à partir des faces avant et arrière et les tranches comportent alors en outre un ou plusieurs contacts sur leur face arrière.

Les différentes étapes (masquage, dépôt ou croissance d'isolant, implantation/diffusion, nettoyage, etc.) de fabrication des composants semiconducteurs imposent de multiples manipulations des tranches de silicium par lot ou individuellement. Or, les tranches de silicium sont très fragiles (cassantes) et ces manipulations engendrent des risques de casse très élevés. De plus, plus sa surface est importante, plus la tranche est fragile pour une épaisseur donnée.

Pour résoudre ce problème de fragilité, on donne aux tranches une épaisseur minimale qui dépend de leur diamètre. Les dimensions actuelles des tranches de silicium sont comprises entre 100 mm et 200 mm de diamètre et on envisage des diamètres encore plus grands. Par exemple, pour des tranches de 200 mm de diamètre dans lesquelles doivent être formés des circuits intégrés, on prévoit généralement une épaisseur de l'ordre de 800 µm.

Le plus souvent, on est conduit à amincir (rectifier) la tranche de silicium par sa face arrière avant de découper les circuits intégrés et de les monter dans les boîtiers. Une telle rectification peut avoir plusieurs objectifs.

Un premier objectif est de respecter les dimensions des boîtiers conçus pour recevoir des circuits formés dans des tranches de diamètre inférieur (donc d'une épaisseur moindre).

Un deuxième objectif est d'éliminer des implantations/diffusions parasites présentes en face arrière et susceptibles d'engendrer des défauts de fonctionnement.

Une telle rectification en fin de procédé de traitement des tranches réduit les risques de casse pendant les premières étapes de traitement des tranches entières. Toutefois, les tranches amincies deviennent extrêmement fragiles pour les étapes ultérieures (métallisation, nettoyage, découpe des puces, etc.) et les manipulations qu'elles entraînent. En outre, cette fragilité mécanique se retrouve dans les puces de circuits intégrés réalisés.

Le procédé le plus couramment utilisé pour amincir les tranches en fin de processus de fabrication de circuits intégrés consiste à utiliser une meule diamantée pour rectifier la face arrière des tranches et diminuer ainsi leur épaisseur finale.

Pour réaliser des composants de puissance, la tranche de silicium est dopée à partir de ses deux faces. L'épaisseur finale de la tranche doit donc être fixée avant les étapes de formation des composants. La tranche de silicium est donc, lors d'une rectification initiale, ramenée à l'épaisseur finale du substrat (généralement comprise entre 200 µm et 400 µm selon le diamètre de la tranche). Dans cette technologie, on utilise généralement un procédé de polissage mécanochimique qui permet d'obtenir une meilleure planéité des surfaces que des procédés de meulage ou de gravure chimique qui constituent d'autres méthodes de rectification.

Il serait souhaitable de pouvoir diminuer encore l'épaisseur de la tranche, en particulier, pour faciliter les opérations d'implantation/diffusion dans l'épaisseur de la tranche. Toutefois, une telle diminution d'épaisseur n'est actuellement pas envisagée pour des raisons de fragilité. En effet, la limite d'épaisseur de la tranche est actuellement fixée par le critère de résistance mécanique minimale acceptable pour ne pas avoir trop de pertes lors des manipulations. Avec les épaisseurs actuelles comprises entre 200 µm et 400 µm, les tranches sont déjà extrêmement fragilisées par rapport aux tranches utilisées pour former des circuits intégrés.

Un objet de la présente invention est de proposer une nouvelle tranche de silicium d'épaisseur sensiblement constante qui soit moins fragile que les tranches actuelles et qui, en particulier, soit moins cassante.

Un autre objet de l'invention est de proposer une tranche de silicium permettant d'améliorer la résistance mécanique de circuits intégrés réalisés à partir de cette tranche.

Une caractéristique de la présente invention est de prévoir un amincissement d'une tranche de silicium jusqu'à une épaisseur inférieure à environ 80 µm.

Alors que la fragilité d'une tranche de faible épaisseur dans l'état de la technique conduisait à augmenter son épaisseur, la présente invention prévoit, à l'inverse, de diminuer l'épaisseur de la tranche. En effet, la demanderesse a constaté qu'en passant en dessous d'un seuil d'épaisseur de l'ordre de 80 µm, la tranche de silicium n'est plus cassante. Elle devient flexible.

En se référant à d'autres matériaux, on pourrait penser que la fragilité reste, pour le silicium, liée à l'épaisseur. En effet, l'oxyde de silicium (SiO₂) qui est couramment utilisé dans des épaisseurs extrêmement fines (quelques centaines d'angströms à quelques µm) reste très cassant. Pour rendre l'oxyde de silicium moins cassant, il est nécessaire d'y incorporer des adjuvants afin de produire des verres qui, à certaines épaisseurs et selon les adjuvants utilisés, peuvent devenir moins cassants. Toutefois, de telles adjonctions sont difficilement compatibles avec l'emploi du silicium dans le domaine des semiconducteurs.

Ainsi, par rapport à l'état de la technique, la présente invention produit au moins deux effets surprenants.

Un premier effet surprenant est qu'une tranche d'une épaisseur inférieure à 80 µm fléchit plutôt que de se briser lorsqu'elle subit une contrainte mécanique et que la flexibilité de la tranche ne s'accompagne d'aucune altération du silicium monocristallin qui la constitue du point de vue de sa fonction de matériau semiconducteur.

Un deuxième effet surprenant est que la tranche retrouve sa forme initiale plane dès que la contrainte mécanique disparaît et ne porte pas de trace de la flexion opérée.

En outre, ces caractéristiques sont indépendantes du plan cristallin dans lequel est formé le lingot de silicium à partir duquel est obtenue la tranche.

Un autre objet de la présente invention est de proposer un procédé d'amincissement d'une tranche de silicium selon l'objet de la revendication 5 qui soit particulièrement adapté à l'obtention de tranches de silicium d'épaisseur très faible et sensiblement constante.

Pour atteindre cet objet, une caractéristique de la présente invention est de prévoir une étape de polissage mécanochimique dans laquelle la tenue de la tranche contre son support est uniquement assurée par un vide moléculaire entre la tranche et son support.

Plus précisément, la présente invention prévoit une tranche de silicium monocristallin présentant une épaisseur inférieure à 80 µm.

Selon un avantage de la présente invention, la tranche de silicium est flexible et élastique en flexion.

Selon un mode de réalisation de la présente invention, la tranche de silicium présente une épaisseur donnée comprise entre 25 et 60 µm.

Selon un mode de réalisation de la présente invention, la tranche de silicium constitue un substrat pour la fabrication de composants semiconducteurs de puissance.

Selon un mode de réalisation de la présente invention, la tranche de silicium comporte, sur une face avant, des éléments définissant un circuit intégré.

La présente invention prévoit également un procédé d'amincissement d'une tranche de silicium monocristallin consistant à amincir la tranche jusqu'à obtenir une épaisseur inférieure à 80 µm.

Selon un mode de réalisation de la présente invention, ce procédé consiste à effectuer une rectification par polissage mécanochimique d'au moins une première face de la tranche de silicium et à suspendre la tranche à un dispositif de maintien destiné à être entraîné dans un mouvement de rotation épicycloïdal par rapport à un feutre de polissage, uniquement en créant un vide moléculaire entre la seconde face de la tranche et un support plan du dispositif de maintien.

Selon un mode de réalisation de la présente invention, le procédé consiste à effectuer une gravure chimique d'au moins la première face de la tranche, avant d'effectuer le polissage mécanochimique.

La présente invention prévoit également un composant semiconducteur de puissance comportant un substrat de silicium d'une épaisseur inférieure à 80 µm.

La présente invention prévoit également une puce de circuit intégré d'une épaisseur inférieure à 80 µm.

La demande de brevet DD-A-217 246 décrit une tranche de silicium pouvant avoir une épaisseur inférieure à 50 µm pour des analyses aux rayons X. Ce document écarte toute fabrication par meulage et indique que le procédé qu'il utilise conduit à des inégalités d'épaisseur de ±10 µm. Ceci signifie qu'une tranche d'une épaisseur nominale de 50 µm présentera par endroits une épaisseur de 40 µm et par endroits une épaisseur de 60 µm. Ceci rend la tranche totalement inadaptée à constituer un substrat de composants semiconducteur.

Par contre, un avantage du procédé par meulage utilisé selon la présente invention est qu'il permet d'obtenir des plaquettes d'épaisseur sensiblement constante.

Ces objets, caractéristiques et avantages, ainsi que d'autres de la présente invention seront exposés en détail dans la description suivante de modes de réalisation particuliers faite à titre non-limitatif.

Le procédé d'amincissement qui sera décrit par la suite constitue une solution particulièrement adaptée à l'obtention de tranches de silicium très minces.

Ce procédé met en oeuvre une étape de polissage mécanochimique utilisant un équipement classique, par exemple, un appareil connu sous la dénomination commerciale "MECAPOL 660E".

Un tel appareil est généralement constitué d'un plateau de relative grande dimension et à la surface supérieure duquel est collé un feutre de polissage. Une tranche de silicium à polir est placée dans un porte-échantillon destiné à être suspendu au-dessus du plateau pour que la surface à polir de la tranche puisse porter contre le feutre de polissage. La tranche est suspendue à un support, lui-même collé à un disque de maintien monté dans le porte-échantillon. Le disque est généralement tenu par aspiration dans le porte-échantillon.

Lors de l'opération de polissage, le plateau est entraîné en rotation. Le porte-échantillon, suspendu à un mécanisme d'entraînement par l'intermédiaire d'un bras à rotule, est entraîné en rotation dans un mouvement épicycloïdal et de balayage transversal alternatif, et est abaissé pour que la tranche soit en contact avec le feutre.

Le support est généralement en un matériau choisi pour que la tranche soit, en l'absence de mouvement latéral, maintenue contre le support par tension superficielle de sa face opposée à la surface à polir. En effet, la planéité de la surface, en particulier lorsque cette face a déjà été polie, permet que la tranche adhère verticalement face contre face au support. Toutefois, il est connu qu'une surface bien polie adhère contre une autre surface plane mais que les deux surfaces peuvent glisser l'une par rapport à l'autre.

Ainsi, un équipement de polissage mécanochimique classique comporte généralement un cadre périphérique collé sur le support, ou le cas échéant sur le disque. Ce cadre est d'une hauteur suffisante pour dépasser du support, afin de maintenir latéralement la tranche.

Pour permettre l'amincissement d'une tranche de silicium jusqu'à obtenir une épaisseur inférieure à 80 µm, l'équipement utilisé est, selon l'invention, dépourvu de cadre de maintien latéral de la tranche. Cette absence de recours à un cadre de maintien latéral permet de supprimer toute marge d'épaisseur par rapport à la face de la tranche opposée à la face à polir et, par conséquent, d'effectuer un polissage mécanochimique jusqu'à une épaisseur très fine.

Le disque de maintien du support est choisi pour être rigide et pour présenter une surface la plus plane possible côté support. Par exemple, on peut utiliser un disque en inox ou, pour sa légèreté, en aluminium, ces deux matériaux étant adaptés à l'obtention de surfaces planes.

Selon l'invention, le support est choisi pour présenter les caractéristiques suivantes.

Tout d'abord, ce support présente une souplesse suffisante pour absorber des tolérances de planéité du disque rigide et de la face de la tranche opposée à la face à polir. En particulier, si la tranche doit être polie sur ses deux faces, la face qui se trouve cachée lors du polissage d'une première face ne présente pas une planéité parfaite.

De plus, dans le cas d'un polissage utilisé pour amincir l'épaisseur finale d'une tranche de silicium après implantation de circuits intégrés, la face avant de la tranche qui n'est pas à rectifier n'est pas parfaitement plane en raison de marches réalisées lors de la fabrication des circuits.

En outre, au moins au début du polissage, la tranche présente une épaisseur dans laquelle elle est très cassante. Il en découle que la moindre poussière ou le moindre défaut entre le support et la tranche risque d'entraîner, lors du polissage, un bris de la tranche. Le support doit donc pouvoir constituer, par sa souplesse, un matelas pour la tranche.

Le support est de plus choisi pour être parfaitement plan afin de respecter le parallélisme entre les deux faces de la tranche. Pour que la souplesse du support ne soit pas préjudiciable au parallélisme des deux faces de la tranche, le support est, de préférence, fin (par exemple, d'une épaisseur inférieure à 5 mm).

De préférence, le support sera choisi pour présenter une compressibilité comprise entre 5 et 20% et une épaisseur inférieure à 2 mm.

Selon un mode de réalisation de l'invention, le support est constitué d'un matériau microporeux associé, sur une face, à une pellicule vulcanisable pour permettre sa fixation au disque. Le matériau doit être tel que sa surface ne durcisse pas après vulcanisation. Par exemple, on pourra utiliser un matériau connu sous la dénomination commerciale "NEWMAN, Pb100-AD8" qui présente une épaisseur de 1,5 mm.

Selon un autre mode de réalisation préféré de l'invention, le support est en polyester/polyuréthanne microporeux, collé à froid sur le disque par l'intermédiaire d'une fine pellicule adhésive. Par exemple, on pourra utiliser un matériau connu sous la dénomination commerciale "RODEL WB20" qui présente une épaisseur globale, c'est-à-dire incluant la pellicule adhésive, de l'ordre de 0,5 mm, voire inférieure.

A titre d'exemple de matériau non retenu pour constituer le support, on citera un matériau connu sous la dénomination commerciale "RODEL DF200" qui, au sens de l'invention, n'est pas suffisamment poreux pour permettre une adhésion de la tranche empêchant ses mouvements latéraux lors du polissage.

La mise en oeuvre du procédé d'amincissement selon la présente invention s'effectue de la manière suivante.

On commence, de préférence, par soumettre la tranche à une étape de gravure chimique, par exemple de sa face arrière, pour diminuer son épaisseur. Puis, on soumet la tranche à une étape de polissage mécanochimique d'au moins sa face arrière. L'épaisseur de la tranche en fin de gravure chimique correspond, de préférence, à l'épaisseur finale souhaitée, majorée d'au moins 25 µm par face à polir.

Un avantage de recourir à une gravure chimique entre une éventuelle rectification par meulage et le polissage mécanochimique est que la gravure peut s'effectuer par lot d'une centaine de tranches, alors que le polissage s'effectue tranche par tranche ou par groupe de 2 à 3 tranches. Comme les durées nécessaires à une réduction d'épaisseur donnée sont sensiblement du même ordre de grandeur, on réduit le temps de traitement rapporté à une tranche. De plus, on évite ainsi les risques de casse liés à un échauffement lors du polissage, et on augmente le nombre de tranches pouvant être polies par un même feutre en limitant son encrassement.

Quand le support microporeux est neuf, celui-ci est mouillé avant de positionner une tranche de silicium à traiter afin d'améliorer l'adhésion de la tranche contre le support. De plus, on place de préférence ce support associé au disque sous presse avec une tranche de silicium de même diamètre que les tranches à polir, pour former une empreinte de très faible profondeur dans le support. Une telle empreinte optimise le maintien latéral des tranches à polir qui seront ensuite placées contre le support.

La préparation d'un support neuf consiste à coller un support microporeux sur un disque de l'appareil. Par exemple, si on utilise un matériau collé à froid pour le support, on applique le support par sa face collante sur la surface plane du disque, puis on place l'ensemble sous presse pour éliminer toutes les microbulles d'air susceptibles d'être logées entre le support et le disque. On voit ici apparaître un autre avantage de l'utilisation d'un matériau microporeux pour le support. La surface libre du support est, pendant cette étape de presse, de préférence, protégée par une feuille de propreté afin d'éviter l'inclusion de poussières dans la surface d'accrochage ultérieure des tranches.

La mise en place d'une tranche s'effectue en plaquant la surface de la tranche, opposée à la surface à polir, contre la surface libre du support. En appliquant une légère pression régulière sur la tranche, on crée, entre la tranche et le support et grâce à l'utilisation d'un matériau microporeux, un vide moléculaire permettant l'adhésion de la tranche contre le support. Bien entendu, on veillera, en raison de la fragilité de la tranche de silicium qui est, au moins avant traitement, très cassante, à ne pas appliquer une pression trop importante.

L'ensemble est alors monté dans le porte-échantillon. Puis, on procède au polissage mécanochimique de la surface de façon classique en apportant, par l'intermédiaire d'un distributeur, une solution de polissage, par exemple, une solution de silice colloïdale et de potasse (KOH) liquide.

L'épaisseur finale de la tranche est directement liée à la durée du polissage mécanochimique. Selon la présente invention, le polissage mécanochimique est, de préférence, effectué jusqu'à ce que l'épaisseur de la tranche devienne inférieure à 80 µm et, de préférence, soit comprise entre 25 et 60 µm.

Si l'amincissement de l'épaisseur de la tranche est réalisé après implantation des composants électroniques dans le silicium, la rectification est effectuée sur une seule face (la face opposée aux composants). Par contre, l'amincissement d'une tranche de silicium avant implantation de composants s'effectue sur les deux faces, en particulier, pour la réalisation de composants de puissance. Dans ce cas, on commence par rectifier une première face de la tranche, puis on la retourne pour rectifier sa deuxième face jusqu'à obtenir l'épaisseur finale souhaitée. Une rectification par polissage des deux faces de la tranche améliore, pour une épaisseur finale inférieure à 80 µm, la capacité de flexion de la tranche obtenue par rapport à une rectification sur une seule face.

Pour "décoller" une tranche en fin de cycle de polissage, on peut utiliser, par exemple, un fil de Nylon que l'on passe entre la tranche et le support. De préférence, on utilise une feuille, par exemple une feuille de papier non pelucheux, de faible épaisseur (par exemple de l'ordre de 80 µm) qui présente l'avantage, en particulier si la tranche doit être retirée avant d'avoir atteint une épaisseur la rendant flexible, de minimiser les risques d'ébréchure périphérique de cette tranche. Dans le cas où l'adhésion est telle que la résistance au décollement ne permet pas d'enlever la tranche au moyen d'une feuille de papier, le support et la tranche sont douchés, par exemple à l'eau, ce qui favorise le décollement en réintroduisant de l'eau dans les pores du support.

L'utilisation d'une tranche de silicium d'épaisseur très mince selon l'invention présente de multiples avantages.

Un premier avantage est que la tranche obtenue est flexible. Cet avantage a de multiples conséquences favorables pour la fabrication des composants semiconducteurs. Tout d'abord, cette flexibilité rend la tranche moins fragile, en particulier, moins cassante qu'une tranche classique. Ainsi, on minimise les risques de casse lors des manipulations des tranches entre les différents postes de traitement servant à fabriquer les composants semiconducteurs qu'ils soient discrets ou intégrés.

La flexibilité de la tranche augmente avec la diminution de son épaisseur. Par exemple, une tranche d'un diamètre de 125 mm et d'une épaisseur de 50 µm selon l'invention peut être prise, par ses bords, entre deux doigts et être fléchie jusqu'à former un U dont les branches sont sensiblement parallèles. Avec une tranche de même diamètre mais de 25 µm d'épaisseur, une manipulation similaire conduit à faire se toucher les deux bords opposés.

La flexibilité de la tranche se traduit par une souplesse des composants réalisés, en particulier, des puces de circuit intégré une fois découpées. Or, on constate que les différents niveaux de métallisation rapportés sur une tranche de silicium très mince selon l'invention préservent la flexibilité du circuit réalisé. Pour réaliser une puce souple, on pourra remplacer l'oxyde de silicium, généralement utilisé comme isolant entre les différents niveaux de métallisation, par un matériau plus souple, par exemple, une résine organique (par exemple, un polyamide-imide).

Un avantage de disposer alors d'un circuit intégré qui est non seulement souple, mais présente également une élasticité lui permettant de retrouver toutes ses caractéristiques à la fois structurelles et électriques, est que les puces de circuit intégré deviennent ainsi beaucoup moins fragiles. Un exemple d'application où la présente invention est particulièrement avantageuse concerne le domaine des cartes dites "à puce", de "crédit" ou de "pré-paiement", dans lequel une puce de circuit intégré est incluse dans une fine carte plastique. Dans une telle application, on facilite l'encartage des puces, la carte pouvant rester souple, et on améliore la durée de vie des cartes dans la mesure où la puce ne risque alors plus d'être détruite par des manipulations de l'utilisateur.

Un autre avantage de l'invention est que, avec une tranche très mince, devant par exemple constituer le substrat d'un composant de puissance, il est plus facile et plus rapide d'obtenir un niveau de dopage homogène. De plus, et bien évidemment, on simplifie et accélère beaucoup la formation de murs d'isolement destinés à former, dans le substrat, des caissons isolés.

Un autre avantage, en particulier pour la réalisation de transistors MOS de puissance dans l'épaisseur d'un substrat de type N, est que l'on minimise la résistance drain-source à l'état passant des transistors réalisés.

## Revendications

1. Tranche de silicium monocristallin, **caractérisée en ce qu'**elle présente une épaisseur sensiblement constante inférieure à 80 µm et **en ce qu'**elle est destinée à constituer un substrat pour la fabrication de composants semiconducteurs.

2. Tranche de silicium selon la revendication 1, **caractérisée en ce qu'**elle présente une épaisseur donnée comprise entre 25 et 60 µm.

3. Tranche de silicium selon la revendication 1 ou 2, **caractérisée en ce qu'**elle constitue un substrat pour la fabrication de composants semiconducteurs de puissance.

4. Tranche de silicium selon l'une quelconque des revendications 1 à 3, **caractérisée en ce qu'**elle comporte, sur une face avant, des éléments définissant un circuit intégré.

5. Procédé d'amincissement d'une tranche de silicium monocristallin jusqu'à obtenir une épaisseur inférieure à 80 µm, **caractérisé en ce qu'**il consiste à effectuer une rectification par polissage mécanochimique d'au moins une première face de la tranche de silicium ; et **en ce qu'**il consiste à suspendre la tranche à un dispositif de maintien destiné à être entraîné dans un mouvement de rotation épicycloïdal par rapport à un feutre de polissage, uniquement en créant un vide moléculaire entre la seconde face de la tranche et un support plan du dispositif de maintien, ledit support comprenant un matériau souple et microporeux présentant une compressibilité comprise entre 5 et 20% et une épaisseur inférieure à 5 mm.

6. Procédé selon la revendication 5, **caractérisé en ce qu'**il consiste à effectuer une gravure chimique d'au moins la première face de la tranche, avant d'effectuer le polissage mécanochimique.

7. Composant semiconducteur de puissance, **caractérisé en ce qu'**il comporte un substrat de silicium d'une épaisseur inférieure à 80 µm.

8. Puce de circuit intégré, **caractérisée en ce qu'**elle a une épaisseur inférieure à 80 µm.

## Patentansprüche

1. Einkristalline Siliciumscheibe, **dadurch gekennzeichnet, dass** sie eine hoch konstante Dicke kleiner als 80 µm aufweist, und dass sie dazu bestimmt ist, ein Substrat für die Herstellung von Halbleiterkomponenten zu bilden.

2. Siliciumscheibe nach Anspruch 1, **dadurch gekennzeichnet, dass** sie eine Dicke aufweist, die zwischen 25 und 60 µm liegt.

3. Siliciumscheibe nach Anspruch 1 oder 2, **dadurch gekennzeichnet, dass** sie ein Substrat für die Herstellung von Halbleiter-Leistungskomponenten bildet.

4. Siliciumscheibe nach einem der vorhergehenden Ansprüche 1 bis 3, **dadurch gekennzeichnet, dass** sie auf einer Vorderseite Elemente trägt, die eine integrierte Schaltung definieren.

5. Verfahren zum Verringern der Dicke einer einkristallinen Siliciumscheibe, bis eine Dicke kleiner als 80 µm erhalten wird, **dadurch gekennzeichnet, dass** eine Begradigung durch mechanochemisches Polieren zumindest einer ersten Seite der Siliciumscheibe durchgeführt wird; und dass die Scheibe allein durch Erzeugen eines molekularen Vakuums zwischen der zweiten Seite der Scheibe und einer Stützebene einer Haltevorrichtung in die Haltevorrichtung eingehängt wird, die in eine epizykloidische Rotationsbewegung in Bezug zu einem Polierfilz versetzbar ist, wobei die Stützfläche ein weiches und mikroporöses Material aufweist, das eine Kompressibilität im Bereich zwischen 5 und 20 % und eine Dicke kleiner als 5 mm hat.

6. Verfahren nach Anspruch 5, **dadurch gekennzeichnet, dass** vor dem mechanochemischen Polieren eine chemische Ätzung zumindest der ersten Seite der Scheibe vorgenommen wird.

7. Halbleiter-Leistungskomponente, **dadurch gekennzeichnet, dass** sie ein Siliciumsubstrat mit einer Dicke kleiner als 80 µm aufweist.

8. Chip für eine integrierte Schaltung, **dadurch gekennzeichnet, dass** er eine Dicke kleiner als 80 µm hat.

## Claims

1. A single-crystal silicon wafer, **characterized in that** it has a substantially constant thickness lower than 80 µm and it is adapted to be used as a substrate for the manufacturing of semiconductor components.

2. The silicon wafer of claim 1, **characterized in that** it has a thickness selected between 25 and 60 µm.

3. The silicon wafer of claim 1 or 2, **characterized in that** it forms a substrate for the manufacturing of semiconductor power components.

4. The silicon wafer of any of claims 1 to 3, **characterized in that** it comprises, on a front surface, elements defining an integrated circuit.

5. A method of thinning of a single-crystal silicon comprising thinning the wafer until a thickness lower than 80 µm is obtained, **characterized in that** it consists in performing a rectification by mechano-chemical polishing of at least one first surface of the silicon wafer; and hanging the wafer to a holding device, to be driven in an epicycloidal rotating motion with respect to a polishing felt, only by creating a molecular vacuum between the second surface of the wafer and a planar bearing of the holding device, said bearing comprising a supple and microporous material having a compressibility included between 5 and 20% and a thickness lower than 5 mm.

6. The method of claim 5, **characterized in that** it comprises performing a chemical etch of at least one first surface of the wafer, before performing the mechano-chemical polishing.

7. A semiconductor power component, **characterized in that** it comprises a silicon substrate of a thickness lower than 80 µm.

8. An integrated circuit chip, **characterized in that** it has a thickness lower than 80 µm.
